# EUROPEAN PATENT APPLICATION

(11) **EP 4 823 309 A1**
(43) Date of publication of application: **14.10.2026**
(21) Application number: 26163480.2
(22) Date of filing: 10.03.2026
(51) Int. Cl.: H10W 70/40, H10W 70/04, H10W 72/00, H10W 72/20, H10P 72/70, H10W 74/10

(54) **DIE ATTACHMENT STRUCTURE AND METHOD**

(30) Priority: 08.04.2025 US 202519173045
(71) Applicant: NXP USA, Inc., Austin, TX 78735 (US)
(72) Inventor: Kim, Jaeyun, 5656AG Eindhoven (NL); Lau, Teck Beng, 5656AG Eindhoven (NL); Chua, Rho Wen, 5656AG Eindhoven (NL); Eu, Poh Leng, 5656AG Eindhoven (NL); Mohd Sukemi, Norazham, 5656AG Eindhoven (NL); Macatangay, Antonio Aguinaldo Marquez, 5656AG Eindhoven (NL)
(74) Representative: Colaiuda, Antonella

(57) **Abstract**

The present disclosure relates to a package assembly including an integrated circuit die having standoff structures and associated methods of die attach and fabrication. The package may include an integrated circuit die having standoff structures disposed on a bottom surface of the integrated circuit die, a die pad structure on which the integrated circuit die is disposed, and die attach material disposed between the integrated circuit die and the die pad structure. The standoff structures can include metallic ink. The standoff structures may contact an upper surface of the die pad structure. The die attach material may attach the integrated circuit die to the die pad structure.

## Description

### TECHNICAL FIELD

Embodiments of the subject matter described herein relate generally to structures and methods for die attachment, including attachment of an integrated circuit die to a lead frame.

### BACKGROUND

Integrated circuit (IC) die are typically housed in a package that includes input/output (I/O) leads, which typically provide electrical connections between internal circuitry (the IC die) and external circuitry. An IC die may be packaged in a number of different carrier or package configurations, for example, quad flat package (QFP), quad flat no-lead (QFN), ball grid array (BGA), and the like, some of which include a lead frame to which the IC die is attached. Such packages protect the IC die and the connections to the IC die and allow for various types of external connections. At higher frequencies, such as radio frequencies, it becomes increasingly desirable to minimize parasitics or other non-idealities between an IC die and the package, such as those attributable to voids or other structural defects at locations where the IC die is attached to the package.

### BRIEF DESCRIPTION OF DRAWINGS

A more complete understanding of the subject matter may be derived by referring to the detailed description and claims when considered in conjunction with the following figures, wherein like reference numbers refer to similar elements throughout the figures. Elements in the figures are illustrated for simplicity and clarity and have not necessarily been drawn to scale. The figures along with the detailed description are incorporated and form part of the specification and serve to further illustrate examples, embodiments and the like, and explain various principles and advantages, in accordance with the present disclosure, wherein:
FIG. 1 shows a top-down view of an illustrative partial package assembly that includes an integrated circuit (IC) die having a bottom side on which standoff structures are formed, where the IC die is attached to a die pad via die attach material, in accordance with various embodiments;
FIG. 2 shows a cross-sectional side view of the partial package assembly of FIG. 1 along the line A-A', in accordance with various embodiments;
FIG. 3 shows cross-sectional views depicting stages of an illustrative die attach process by which an IC die may be attached to a die pad to form the partial package assembly of FIGS. 1 and 2, in accordance with various embodiments;
FIG. 4 shows a process flow diagram describing a method of packaging an IC die having standoff structures, in accordance with various embodiments;
FIG. 5 shows cross-sectional views depicting stages of a packaging process corresponding to, for example, steps of the method of FIG. 4, in accordance with various embodiments;
FIG. 6 shows a process flow diagram describing a method of die singulation and standoff structure formation in which standoff structures are formed prior to wafer dicing, in accordance with various embodiments;
FIG. 7 shows cross-sectional views depicting stages of a die singulation and standoff structure formation process corresponding to, for example, steps of the method of FIG. 6, in accordance with various embodiments;
FIG. 8 shows a process flow diagram describing a method of die singulation and standoff structure formation in which standoff structures are formed following wafer dicing, in accordance with various embodiments; and
FIG. 9 shows cross-sectional views depicting stages of a die singulation and standoff structure formation process corresponding to, for example, steps of the method of FIG. 8, in accordance with various embodiments.

### DETAILED DESCRIPTION

The following detailed description is merely illustrative in nature and is not intended to limit the embodiments described herein and uses of such embodiments. Furthermore, there is no intention to be bound by any expressed or implied theory presented in the preceding technical field, background, or the following detailed description.

For simplicity and clarity of illustration, the figures illustrate the general manner of construction. Descriptions and details of well-known features and techniques may be omitted from the following detailed description to avoid unnecessarily obscuring the present disclosure. For example, the dimensions of some of the elements or regions in the figures may be exaggerated relative to other elements or regions to help improve understanding of embodiments described herein.

The terms "first," "second," "third," "fourth" and the like in the description and the claims, if any, may be used for distinguishing between similar elements and not necessarily for describing a particular sequential or chronological order. It is to be understood that the terms so used are interchangeable under appropriate circumstances such that the embodiments described herein are, for example, capable of operation in sequences other than those illustrated or otherwise described herein. Furthermore, the terms "comprise," "include," "have" and any variations thereof, are intended to cover non-exclusive inclusions, such that a process, method, article, or apparatus that comprises a list of elements is not necessarily limited to those elements but may include other elements not expressly listed or inherent to such process, method, article, or apparatus. As used herein the terms "approximate," "approximately," "substantial" and "substantially" mean sufficient to accomplish the stated purpose in a practical manner and that minor imperfections, if any, are not significant for the stated purpose.

Along these lines, when used with references to measurable quantities including, but not limited to, dimensions, these terms mean that the quantities are equal to the values stated subject to accepted tolerances of any methods or apparatus chosen to fabricate the described structures or measure the quantities or dimensions described. Directional references such as "top," "bottom," "left," "right," "above," "below," and so forth, unless otherwise stated, are not intended to require any preferred orientation and are made with reference to the orientation of the corresponding figure or figures for purposes of illustration. As used herein, the words "exemplary" and "example" mean "serving as an example, instance, or illustration." Any implementation described herein as exemplary or an example is not necessarily to be construed as preferred or advantageous over other implementations. In addition, certain terms may also be used herein for reference only, and thus are not intended to be limiting.

Herein, elements or nodes or features are sometimes referred to as being "connected" or "coupled" together. As used herein, unless expressly stated otherwise, "connected" means that one element is directly joined to (or directly communicates with) another element in an electrical or non-electrical manner, and not necessarily mechanically. Likewise, unless expressly stated otherwise, "coupled" means that one element is directly or indirectly joined to (or directly or indirectly communicates with) another element in an electrical or non-electrical manner, and not necessarily mechanically. Thus, although the schematic illustrations shown in the figures depict exemplary arrangements of elements, additional intervening elements, devices, features, or components may be present in one or more embodiments of the depicted subject matter.

Various embodiments described herein relate methods for attaching a die, such as an integrated circuit (IC) die, to a pad, such as the die pad of a lead frame or other package structure, where standoff structures formed on a bottom surface of the die mitigate or otherwise reduce the formation of voids in die attach material disposed between the die and the die pad. One or more embodiments herein relate to methods of forming such standoff structures on such a die. In one or more embodiments, the standoff structures may be formed by printing dots of metal ink onto a bottom surface of the die.

Conventional die attach processes typically include attaching an IC die with a planar bottom surface to a die pad using electrically conductive adhesive. However, it is typically difficult to control the Bond Line Thickness (BLT) of the resultant assembly using such conventional processes without the use of specialized equipment, such as a confocal die bonder, however, such equipment tends to be undesirably costly. Additionally, lack of sufficiently controlled BLT can result in a BLT that is too low, which can cause undesirable void formation in die attach material, leading to diminished performance at higher frequencies.

Embodiments herein address these challenges by providing an IC die having standoff structures formed on its bottom side, where the height of these standoff structures controls the distance between the bottom of the IC die and the surface of the die pad during the die attach process, thereby allowing for more precise BLT control. In one or more embodiments, the height of these standoff structures may be selected to ensure an adequately thick BLT, resulting in mitigation of void formation in die attach material used to attach the IC die to the die pad and, therefore, improved electrical performance (e.g., improved RF signal quality) of the IC die.

In one or more embodiments, a package assembly may include at least one IC die having a bottom surface on which standoff structures are formed, where the IC die is attached to an upper metallic layer of a die pad structure using die attach material. In one or more embodiments, the die pad structure may be part of a lead frame. In one or more embodiments, the die attach material may include an electrically conductive paste or epoxy, such as a metallic sinter paste or metallic sinter epoxy as non-limiting examples. The die attach material may include silver or copper, as non-limiting examples. The upper metallic layer of the die pad structure may include silver or copper, as non-limiting examples. In one or more embodiments, the standoff structures may be formed from electrically conductive metallic ink that has been cured and hardened. The electrically conductive metallic ink may include silver or copper, as non-limiting examples. In one or more embodiments, the die attach material and the standoff structures each include the same type of metal (e.g., silver or copper). In one or more embodiments, the die attach material, the standoff structures, and the upper metallic layer of the die pad structure each include the same type of material (e.g., silver or copper).

The standoff structures may be formed by printing the metallic ink onto a bottom surface of the IC die. The standoff structures may all have the same or substantially the same heights. As a non-limiting example, each standoff structure may have a height equal to or approximately equal to 35 µm with a tolerance of +/- 5 µm.
Each of the standoff structures may have a rounded, non-planar surface (e.g., not the surface that contacts the bottom surface of the IC die). In one or more embodiments, four standoff structures may be formed on the bottom surface of the IC die, with one standoff structure being disposed in each corner region of the bottom surface of the IC die. In one or more other embodiments, three standoff structures may be formed on the bottom surface of the IC die, with one standoff structure being near the center of a first edge region of the IC die and two standoff structures being disposed at respective corner regions of a second edge region of the IC die that is opposite the first edge region. In one or more other embodiments, five or more standoff structures may be formed on the bottom of the IC die.

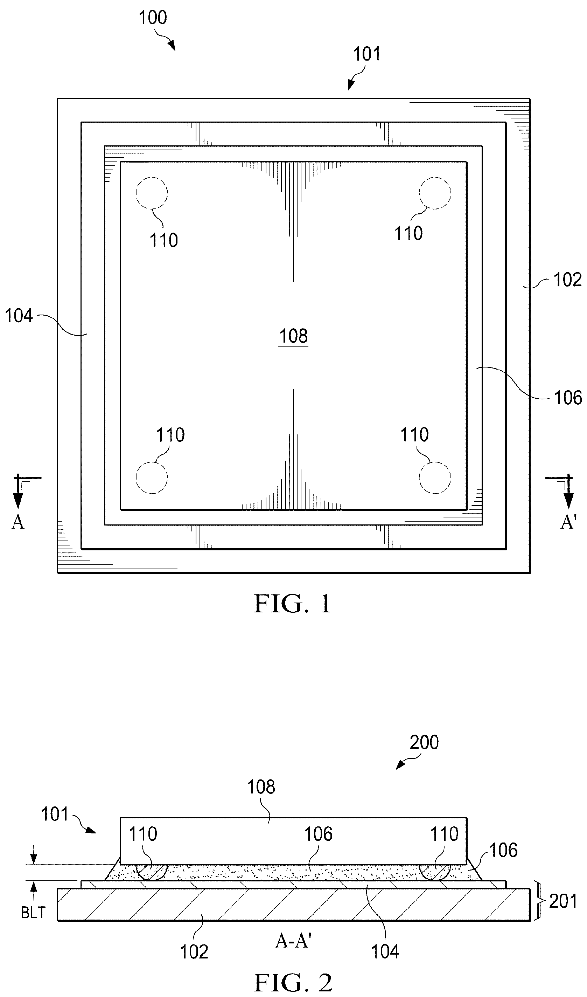

FIGS. 1 and 2 show, respectively, a top-down view 100 and a cross-sectional side view 200 (cross-sectional along the line A-A' shown in the top-down view 100) of a partial package assembly 101 in which an integrated circuit (IC) die 108 having standoff structures 110 is attached to a die pad structure 201. FIGS. 1 and 2 are described here concurrently.

As shown, in the partial package assembly 101 the integrated circuit (IC) die 108 is disposed on a die pad structure 201. The IC die 108 may be attached to the die pad structure 201 using die attach material 106. The standoff structures 110 may be disposed at a bottom surface of the IC die 108.

In one or more embodiments, the die pad structure 201 is the die pad of a lead frame structure. The die pad structure 201 may include a lower metallic layer 102 and an upper metallic layer 104. In one or more embodiments, the upper metallic layer 104 and the lower metallic layer 102 may include respectively different types of metal. As a non-limiting example, the upper metallic layer 104 may be formed from silver and the lower metallic layer 102 may be formed from copper. In one or more embodiments, the upper metallic layer 104 may be a thin film that is formed on the upper surface of the lower metallic layer 102 (e.g., via plating or a thin film deposition process such as sputtering or evaporation, as non-limiting examples).

The standoff structures 110 may be formed by printing the metallic ink onto a bottom surface of the IC die 108. The standoff structures 110 may all have the same or substantially the same heights (e.g., within +/- 5 µm). As a non-limiting example, each standoff structure 110 may have a height equal to or approximately equal to 35 µm with a tolerance of +/- 5 µm. Each of the standoff structures 110 may have a rounded, non-planar surface (e.g., not the surface that contacts the bottom surface of the IC die 108). In one or more embodiments, the diameter of each standoff structure 110 may be at or around 1.5 times a target BLT level (e.g., the desired distance between the bottom surface of the IC die 108 and the upper surface of the die pad structure 201). In one or more embodiments, each standoff structure 110 may have a diameter of around 30 µm to around 40 µm.

In the present example, four standoff structures 110 are formed on the bottom surface of the IC die 108, with one standoff structure 110 being disposed in each corner region of the bottom surface of the IC die 108. However, such an arrangement is intended to be illustrative and non-limiting. For example, in one or more other embodiments, three standoff structures 110 may instead be formed on the bottom surface of the IC die 108, with one standoff structure 110 being near the center of a first edge region of the IC die 108 and two standoff structures 110 being disposed at respective corner regions of a second edge region of the IC die 108 that is opposite the first edge region.

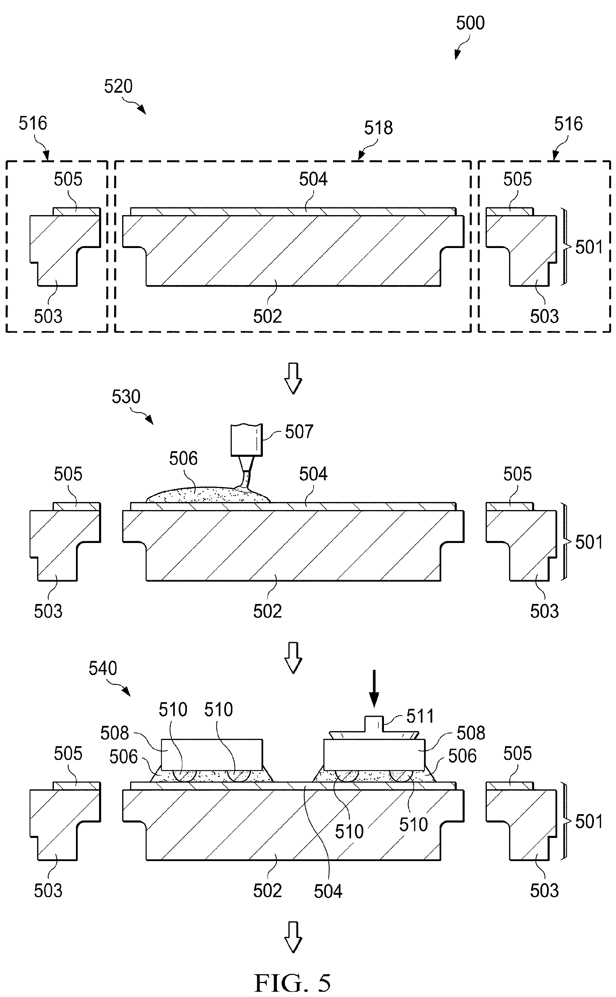

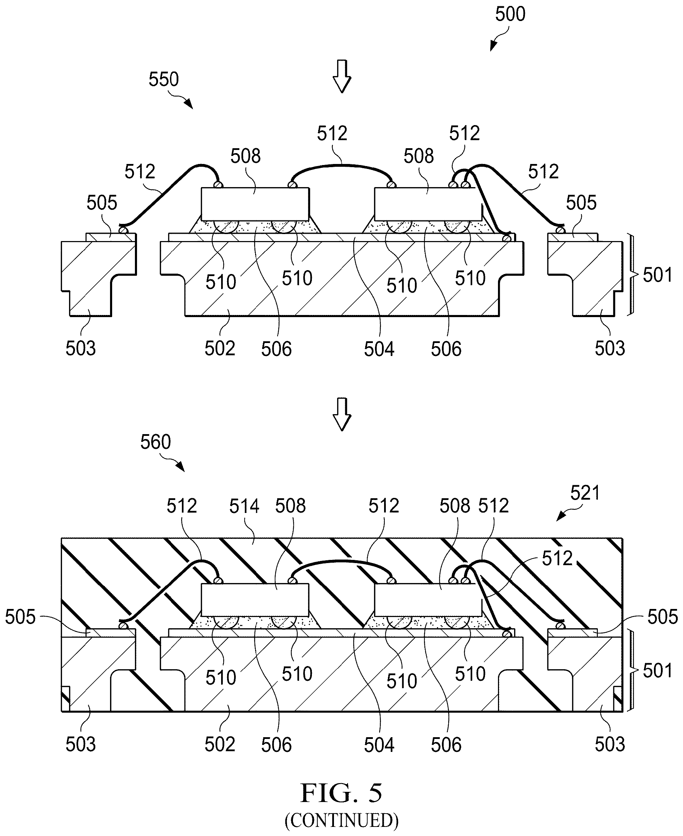

In the present example, a single IC die 108 is attached to the die pad structure 201. However, such an arrangement is intended to be illustrative and non-limiting. For example, in one or more embodiments, two or more IC dies, each having standoff structures in accordance with embodiments described herein, may be attached to a single die pad structure (see, e.g., the process of FIG. 5).

In one or more embodiments, the die attach material 106 may include an electrically conductive paste or epoxy such as a metallic sinter paste or metallic sinter epoxy, as non-limiting examples. In one or more embodiments, the die attach material 106 may completely or substantially fill the space between the IC die 108 and the upper metallic layer 104 of the die pad structure 201. In one or more embodiments, the die attach material 106 may laterally surround each of the standoff structures 110. The die attach material 106 may include silver or copper, as non-limiting examples.

The upper metallic layer 104 of the die pad structure 201 may include silver or copper, as non-limiting examples. In one or more embodiments, the standoff structures 110 may be formed from electrically conductive metallic ink that has been cured and hardened. The electrically conductive metallic ink of the standoff structures 110 may include silver or copper, as non-limiting examples. In one or more embodiments, the die attach material 106 and the standoff structures each include the same type of metal (e.g., silver or copper). In one or more embodiments, the die attach material 106, the standoff structures 110, and the upper metallic layer 104 of the die pad structure each include the same type of metal material (e.g., silver or copper).

Conventional die attach approaches typically involve attaching an IC die with a planar bottom surface to a die pad using electrically conductive adhesive. However, it is typically difficult to control the bond line thickness (BLT) of the resultant assembly using such conventional processes, which can result in undesirably low BLT. Herein, BLT refers to the thickness of the layer of material bonding the die to the die pad, and can alternatively be considered as the distance between the IC die and the die pad following die attach. Inadequately thick BLT can lead to undesirable outcomes, such as increased formation of voids between the IC die and the die pad. For example, non-negligible void formation in the material between an IC die and a die pad may lead to undesirable parasitic impedances that can negatively impact the signal quality of higher frequency signals, such as radio frequency (RF) signals. While some conventional approaches attempt to control BLT through the use of specialized equipment, such as a confocal die bonder, such equipment is undesirably costly.

In comparison, by providing the standoff structures 110 on the bottom side of the IC die 108 as shown in the present example, the BLT, corresponding to the distance between the top surface of the die pad structure 201 and the bottom surface of the IC die 108, is controlled by the height of the standoff structures 110, which increases the precision with which the BLT can be controlled during the die attach process. In one or more embodiments, the height of the standoff structures 110 may be selected to ensure an adequately thick BLT (e.g., a BLT at or around 30 to 40 µm or greater for a die having a thickness at or around 75 µm or less, as a non-limiting example) resulting in mitigation of void formation in die attach material 106 and, therefore, improved electrical performance (e.g., improved RF signal quality) of the IC die 108. It should be understood that an "adequate" BLT may vary depending on the application, the thickness of the IC die 108, and other factors, and that various BLT levels are achievable (e.g., by forming standoff structures of suitable height) with a desirable level of consistency in accordance with various embodiments.

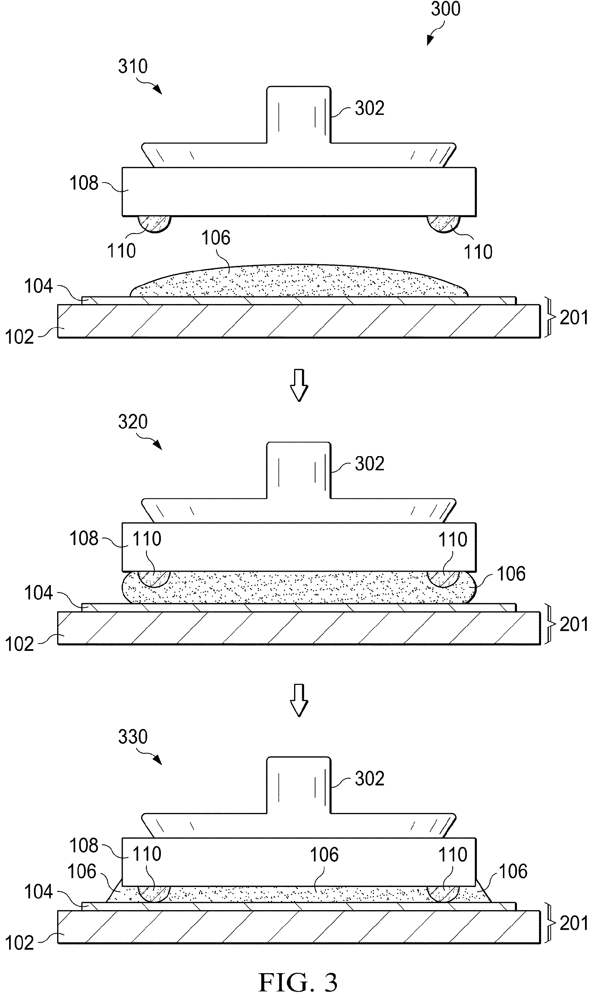

FIG. 3 shows an example of a die attach process 300 by which an IC die with standoff structures, such as the IC die 108 of FIGS. 1 and 2, may be attached to a die pad structure, such as the die pad structure 201 of FIG. 2. The process 300 includes sequential stages 310, 320, and 330. In the present example, the process 300 is described with reference to the IC die 108 of FIGS. 1 and 2, where like reference numerals denote like elements.

At stage 310, a pick-and-place tool 302 carrying the IC die 108 is positioned over die pad structure 201 on which the die attach material 106 has been deposited.

At stage 320, the pick-and-place tool 302 lowers the IC die 108 until the bottom surface of the IC die 108 and the standoff structures 110 make contact with the die attach material.

At stage 330, the pick and place tool 302 continues to lower the IC die 108 until the standoff structures 110 make contact with the upper surface of the die pad structure 201 (e.g., the upper surface of the upper metallic layer 104). At stage 330, the BLT between the IC die 108 and the die pad structure 201 may be equal to a target or desired BLT that is defined by the heigh to the standoff structures 110. Subsequent to stage 330, the pick-and-place tool 302 may be removed, and the resultant partial package assembly may be heated to cure the die attach material 106.

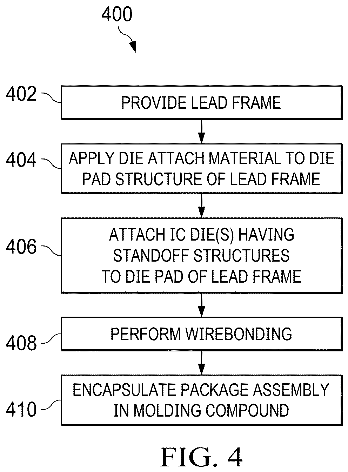

FIG. 4 is a process flow diagram depicting a method 400 for fabricating a package assembly including one or more IC dies, each having standoff structures formed on bottom surfaces thereof, in accordance with various embodiments. In one or more embodiments, the method 400 of FIG. 4 may correspond to the process 500 of FIG. 5, described below.

At block 402, a lead frame is provided, which includes a central die pad structure and surrounding leads. While the present example refers to a lead frame, this is intended to be illustrative and non-limiting. For example, in one or more other embodiments, other suitable package types having a die pad structure may instead be used, such as those with laminated substrates, stacked die structures (e.g., in place of die attach film), or other die and package arrangements for which precise BLT control would be beneficial. Additionally, the use of conductive epoxy, as described herein, may provide improved thermal conductivity compared to die attach film.

At block, 404, die attach material (e.g., silver sinter epoxy or silver sinter paste) is applied to the die pad structure of the lead frame.

At block 406, one or more IC dies are attached to the die pad structure of the lead frame at the location(s) at which the die attach material was applied at block 404. Each IC die may include standoff structures (e.g., the standoff structures 110 of FIGS. 1 and 2) disposed on a bottom side of that IC die. The standoff structures may be formed from metallic ink, such as silver or copper ink, as non-limiting examples. The standoff structures may all have the same or substantially the same heights, and the heights of the standoff structures may determine the BLT for each attached IC die of the package assembly. In one or more embodiments, the die attach material used to attach the IC die(s) to the die pad structure may be thermally cured at block 406 or between block 406 and block 408.

At block 408, wirebonds are formed to connect (e.g., electrically connect) the one or more IC dies to portions of the lead frame or, in one or more embodiments, to connect one IC die to another IC die.

At block 410, the package assembly, including the lead frame and the one or more IC die, is encapsulated in a molding compound. For example, the molding compound may include dielectric material, such as epoxy resin.

FIG. 5 shows an example of a process 500 for fabricating a package assembly 521 having multiple IC dies 508 attached to a die pad structure of a lead frame 501 using die attach material 506, where standoff structures 510 are formed on the bottom side of each IC die 508. The process 500 includes sequential stages 520, 530, 540, 550, and 560. In one or more embodiments, the stages 520, 530, 540, 550, and 560 may correspond, respectively, to example implementations of blocks 402, 404, 406, 408, and 410 of the method 400 of FIG. 4. In accordance with various embodiments, aspects of the IC dies 508, the standoff structures 510, the die pad structure, and the die attach material 506 may be similar to those of corresponding elements of the partial package assembly 101 of FIGS. 1 and 2, and descriptions of such elements are not necessarily repeated here for sake of brevity.

At stage 520, a lead frame 501 is provided, which includes leads 516 and a die pad structure 518. The leads 516 each include a lower metallic layer 503 and an upper metallic layer 505. The die pad structure 518 includes a lower metallic layer 502 and an upper metallic layer 504. The upper metallic layers 504 and 505 may be thin films that are formed (e.g., plated or deposited) on the lower metallic layers 502 and 503, respectively. The upper metallic layers 504 and 505 may include silver or copper, as non-limiting examples.

While the present example refers to a lead frame 501, this is intended to be illustrative and non-limiting. For example, in one or more other embodiments, other suitable package types having a die pad structure may instead be used, such as those with laminated substrates, stacked die structures (e.g., in place of die attach film), or other die and package arrangements for which precise BLT control would be beneficial.

At stage 530, die attach material 506 is dispensed onto an upper surface of the upper metallic layer 504 of the die pad structure 518 using a dispenser 507. The die attach material 506 may include silver sinter paste or silver sinter epoxy, as non-limiting examples.

At stage 540, IC dies 508 are attached to the upper metallic layer 504 of the die pad structure 518 by a pick-and-place tool 511. The pick and place tool may attach the IC dies 508 at the locations at which the die attach material 506 is deposited by the dispenser 507 at stage 530. The IC dies 508 may include standoff structures 510 formed on respective bottom surfaces of the IC dies 508. The standoff structures 510 of a particular IC die 508 may all have the same or substantially the same heights. The heights of the standoff structures 510 of a particular IC die 508 may determine the BLT for that IC die 508 within the package assembly 521. In this way, the standoff structures 510 may advantageously control the BLT level for each IC die 508. When formed with adequate heights, the standoff structures 510 may ensure a sufficiently thick BLT, thereby reducing or otherwise mitigating void formation in the die attach material 506.

At stage 550, wire bonds 512 are created between various structures of the assembly. For example, wire bonds 512 may be created at stage 550 that extend between and provide electrical connection between any of: two of the IC dies 508, an IC die 508 and an upper metallic layer 505 (which acts here as a bond pad) of one of the leads 516, or an IC die 508 and the upper metallic layer 504, as non-limiting examples.

At stage 560, the lead frame 501, the wire bonds 512, and the IC dies 508 are encapsulated in a molding compound 514. For example, the molding compound 514 may include dielectric material, such as epoxy resin.

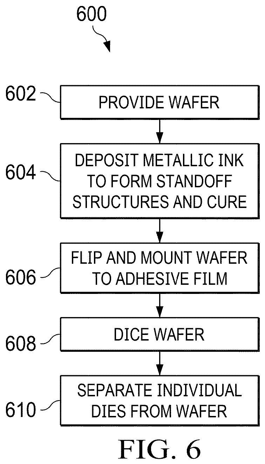

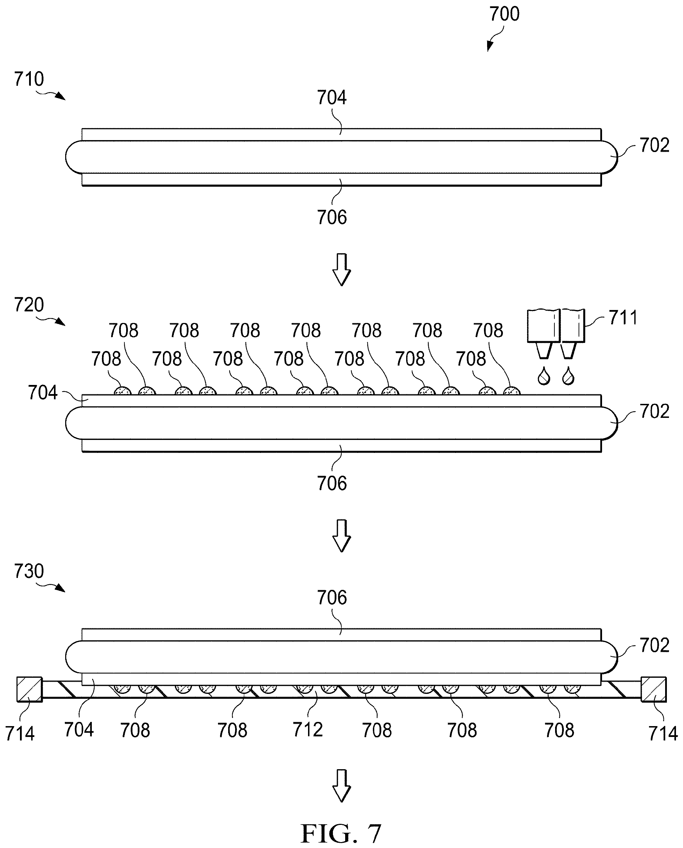

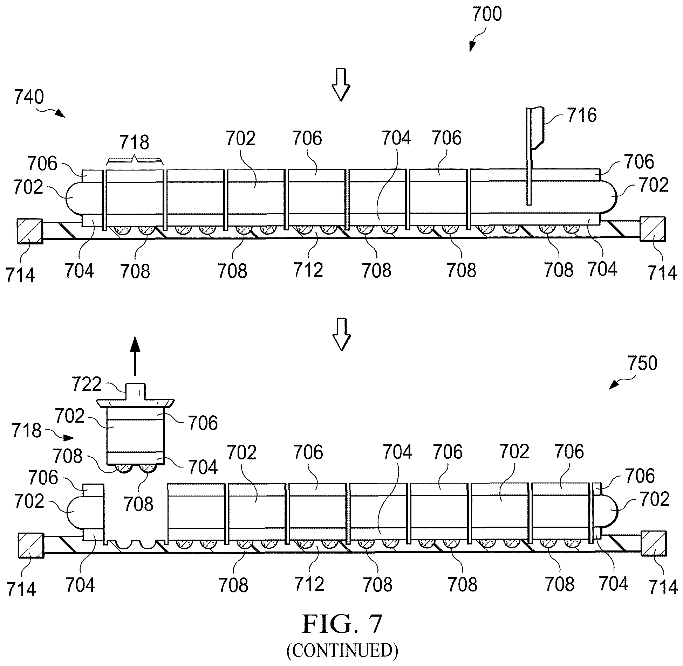

FIG. 6 is a process flow diagram depicting a method 600 for IC die singulation and standoff structure formation in which standoff structures (e.g., the standoff structures 110 of FIGS. 1 and 2, 510 of FIG. 5, or 708 of FIG. 7) are formed prior to wafer dicing. Herein, "die singulation" refers to a process by which a wafer is diced (e.g., using mechanical sawing, laser cutting, or other suitable wafer dicing techniques) into individual IC dies, which are then separated from the wafer. In one or more embodiments, the method 600 of FIG. 6 may correspond to the process 700 of FIG. 7, described below. In accordance with various embodiments, the method 600 may be used to singulate and form the standoff structures of any of the IC die 108 of FIGS. 1-3 or the IC dies 508 of FIG. 5.

At block 602, a wafer is provided, which includes a front side and a back side. The wafer may be a semiconductor wafer that includes multiple ICs.

At block 604, metallic ink is applied (e.g., printed) onto the back side of the wafer as a pattern (e.g., a pattern of dots) to form standoff structures (e.g., the standoff structures 110 of FIG. 1, 510 of FIG. 5, or 708 of FIG. 7). In one or more embodiments, the metallic ink is silver metallic ink or copper metallic ink. Following deposition of the metallic ink, the wafer may be heated to cure the standoff structures.

At block 606, the wafer is flipped (e.g., rotated 180 degrees) and mounted to adhesive film. The back side of the wafer, including the standoff structures, may contact the adhesive film once the wafer is mounted. In one or more embodiments, the adhesive film may be dicing tape formed from polyvinyl chloride (PVC), polyolefin, or polyethylene, as non-limiting examples. In one or more embodiments, the adhesive film may be disposed within a wafer ring.

At block 608, the wafer is diced (e.g., using mechanical sawing, laser cutting, or other suitable wafer dicing techniques) to separate individual IC dies of the wafer.

At block 610, individual IC dies are removed from the wafer. For example, a pick-and-place tool may pick up individual IC dies, removing the IC dies from the adhesive film and separating the IC dies from the wafer.

FIG. 7 shows an example of a process 700 for IC die singulation and standoff structure formation for a wafer 702 in which standoff structures 708 are formed prior to wafer dicing. The process 700 includes sequential stages 710, 720, 730, 740, and 750. In one or more embodiments, the stages 710, 720, 730, 740, and 750 may correspond, respectively, to example implementations of blocks 602, 604, 606, 608, and 610 of the method 600 of FIG. 6.

At stage 710, a wafer 702 is provided, which includes a front side 706 and a back side 704. The wafer 702 may be a semiconductor wafer that includes multiple ICs (e.g., the IC of IC die 718 shown in stages 740 and 750).

At stage 720, a dispenser 711 applies (e.g., prints) metallic ink onto the back side 704 of the wafer 702 to form standoff structures 708. The standoff structures 708 may be formed as patterned dots on the back side 704. In one or more embodiments, the metallic ink used to form the standoff structures 708 is silver metallic ink or copper metallic ink. Following deposition of the metallic ink, the wafer 702 may be heated to cure the standoff structures 708.

At stage 730, the wafer 702 is flipped (e.g., rotated 180 degrees) and mounted to an adhesive film 712. The back side of the wafer 702, including the standoff structures 708, may contact the adhesive film 712 once the wafer 702 is mounted. In one or more embodiments, the adhesive film may be dicing tape formed from polyvinyl chloride (PVC), polyolefin, or polyethylene, as non-limiting examples. In one or more embodiments, the adhesive film 712 may be disposed within a wafer ring 714.

At stage 740, the wafer 702 is diced using a dicing tool 716 (e.g., via mechanical sawing, laser cutting, or other suitable wafer dicing techniques) to separate individual IC dies, such as the IC die 718.

At stage 750, individual IC dies, including the IC die 718, are removed from the wafer. For example, a pick-and-place tool 722 may pick up individual IC dies, such as the IC die 718, removing the IC dies from the adhesive film 712 and separating the IC dies from the wafer 702. In one or more embodiments, the pick-and-place tool 722 may place the IC die 718 onto a die pad (e.g., onto the die pad 201 of FIG. 2) following stage 750 with or without one or more intermediate steps. In one or more embodiments, one or more intermediate steps may be performed after stage 750 and prior to die placement, which may include one or more steps for inspection (e.g., using an upward-facing camera) to detect die offset and rotation may be, and one or more steps for compensating for die offset and rotation, if detected. Such intermediate steps may improve the accuracy of the final die placement.

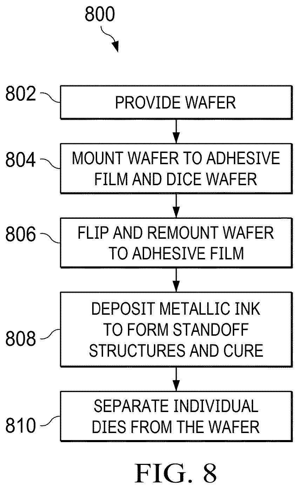

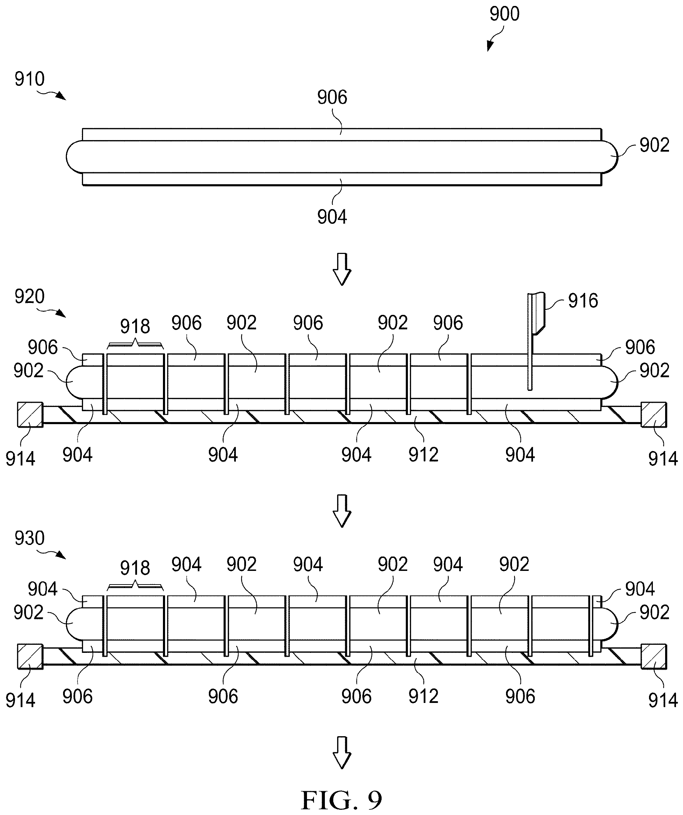

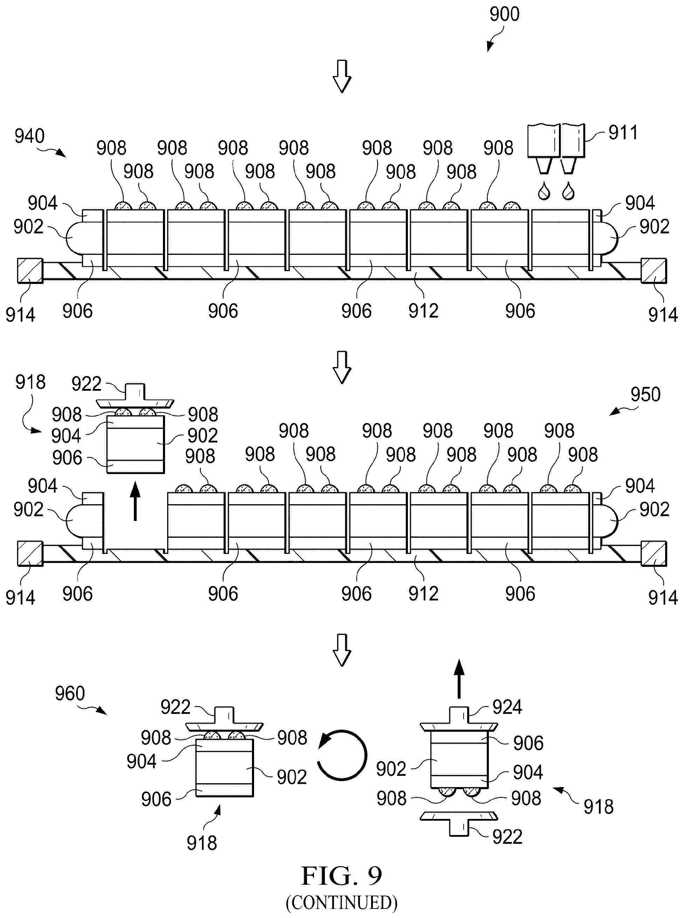

FIG. 8 is a process flow diagram depicting a method 800 for IC die singulation and standoff structure formation in which standoff structures (e.g., the standoff structures 110 of FIGS. 1 and 2 or the standoff structures 510 of FIG. 5) are formed after wafer dicing. In one or more embodiments, the method 800 of FIG. 8 may correspond to the process 900 of FIG. 9, described below. In accordance with various embodiments, the method 800 may be used to singulate and form the standoff structures of any of the IC die 108 of FIGS. 1-3 or the IC dies 508 of FIG. 5.

At block 802, a wafer is provided, which includes a front side and a back side. The wafer may be a semiconductor wafer that includes multiple ICs are formed.

At block 804, the wafer is mounted to adhesive film and is diced (e.g., using mechanical sawing, laser cutting, or other suitable wafer dicing techniques) to separate individual IC dies of the wafer. The back side of the wafer may contact the adhesive film once the wafer is mounted. In one or more embodiments, the adhesive film may be dicing tape formed from polyvinyl chloride (PVC), polyolefin, or polyethylene, as non-limiting examples. In one or more embodiments, the adhesive film may be disposed within a wafer ring.

At block 806, the wafer is flipped (e.g., rotated 180 degrees) and remounted onto adhesive film with the front side of the wafer contacting the adhesive film.

At block 808, metallic ink is applied (e.g., printed) onto the back side of the wafer as a pattern (e.g., a pattern of dots) to form standoff structures (e.g., the standoff structures 110 of FIG. 1, 510 of FIG. 5, or 908 of FIG. 9). In one or more embodiments, the metallic ink is silver metallic ink or copper metallic ink. Following deposition of the metallic ink, the wafer may be heated to cure the standoff structures.

At block 810, individual IC dies are removed from the wafer. For example, a pick-and-place tool may pick up individual IC dies, removing the IC dies from the adhesive film and separating the IC dies from the wafer. In one or more embodiments, an individual IC die may be flipped (e.g., rotated 180 degrees) after being separated from the wafer.

FIG. 9 shows an example of a process 900 for IC die singulation and standoff structure formation for a wafer 902 in which standoff structures 908 are formed after to wafer dicing. The process 900 includes sequential stages 910, 920, 930, 940, 950, and 960. In one or more embodiments, the stages 910, 920, 930, 940, 950, and 960 may correspond, respectively, to example implementations of blocks 802, 804, 806, 808, and 810 of the method 800 of FIG. 8.

At stage 910, a wafer 902 is provided, which includes a front side 906 and a back side 904. The wafer 902 may be a semiconductor wafer that includes multiple ICs (e.g., the IC of IC die 918 shown in stages 940, 950, and 960).

At stage 920, the wafer 902 is mounted to adhesive film 912 and is diced using a dicing tool 916 (e.g., via mechanical sawing, laser cutting, or other suitable wafer dicing techniques) to separate individual IC dies of the wafer, such as the IC die 918. The back side 904 of the wafer 902 may contact the adhesive film 912 once the wafer 902 is mounted. In one or more embodiments, the adhesive film 912 may be dicing tape formed from polyvinyl chloride (PVC), polyolefin, or polyethylene, as non-limiting examples. In one or more embodiments, the adhesive film 912 may be disposed within a wafer ring 914.

At stage 930, the wafer 902 is flipped (e.g., rotated 180 degrees) and remounted onto adhesive film 912 (or, in one or more other embodiments, a separate adhesive film) with the front side 906 of the wafer 902 contacting the adhesive film 912.

In one or other more embodiments, the wafer 902 may be provided pre-diced, and in such embodiments the process 900 may instead begin at stage 930 upon provision of the pre-diced wafer.

At stage 940, a dispenser 911 applies (e.g., prints) metallic ink onto the back side 904 of the wafer 902 to form standoff structures 908. The standoff structures 908 may be formed as patterned dots on the back side 904. In one or more embodiments, the metallic ink used to form the standoff structures 908 is silver metallic ink or copper metallic ink. Following deposition of the metallic ink, the wafer 902 may be heated to cure the standoff structures 908.

At stage 950, individual IC dies, including the IC die 918, are removed from the wafer. For example, a pick-up tool 922 may pick up individual IC dies, such as the IC die 918, removing the IC dies from the adhesive film 912 and separating the IC dies from the wafer 902.

At stage 960, each IC die, including the IC die 918, may be flipped (e.g., rotated 180 degrees) by rotating the pick-up tool 922 and transferring the IC die 918 to a separate pick-and-place tool 924. In this way, the IC die 918, for example, may be rotated to have an orientation that is more suitable to subsequent die attachment (e.g., an orientation in which the standoff structures 908 and the back side 904 of the IC die 918 face away from, rather than toward, the pick-and-place tool carrying the IC die 918.) In one or more embodiments, the pick-and-place tool 924 may place the IC die 918 onto a die pad (e.g., onto the die pad 201 of FIG. 2) following stage 960 with or without one or more intermediate steps. In one or more embodiments, one or more intermediate steps may be performed after stage 960 and prior to die placement, which may include one or more steps for inspection (e.g., using an upward-facing camera) to detect die offset and rotation may be, and one or more steps for compensating for die offset and rotation, if detected. Such intermediate steps may improve the accuracy of the final die placement.

Various exemplary embodiments are presented below. Some simplifications and omissions may be made in the following examples, which are intended to highlight and introduce some aspects of the various exemplary embodiments, without limiting the scope.

In an example embodiment, a method includes forming standoff structures on a bottom surface of an integrated circuit die, wherein the standoff structures include metallic ink, and

attaching the integrated circuit die to a die pad structure using die attach material, wherein the standoff structures contact a surface of the die pad structure after attachment of the integrated circuit die to the die pad structure.

In one or more embodiments, forming the standoff structures on the bottom surface of the integrated circuit die includes forming at least three standoff structures on the bottom surface of the integrated circuit die.

In one or more embodiments, forming the standoff structures on the bottom surface of the integrated circuit die includes printing patterned metallic ink on the bottom surface of the integrated circuit die.

In one or more embodiments, the method further includes dicing a wafer including the integrated circuit die to separate the integrated circuit die from the wafer.

In one or more embodiments, forming the standoff structures is performed prior to dicing the wafer.

In one or more embodiments, forming the standoff structures is performed after dicing the wafer.

In one or more embodiments, the method further includes forming one or more wire bonds between the integrated circuit die and at least one lead of a lead frame that includes the die pad structure.

In one or more embodiments, the method further includes encapsulating the integrated circuit die and the lead frame in molding material.

In one or more embodiments, the die attach material includes silver sinter material.

In one or more embodiments, after attaching the integrated circuit die to a die pad structure, the die attach material laterally surrounds the standoff structures and fills a space between the integrated circuit die and the die pad structure.

In an example embodiment, an integrated circuit die includes standoff structures disposed on a bottom surface of the integrated circuit die, the standoff structures including metallic ink, a die pad structure on which the integrated circuit die is disposed, the standoff structures of the integrated circuit die contacting an upper surface of the die pad structure, and die attach material disposed between the integrated circuit die and the die pad structure, the die attach material attaching the integrated circuit die to the die pad structure.

In one or more embodiments, the standoff structures include at least three standoff structures.

In one or more embodiments, at least two of the standoff structures are disposed at corner regions of the bottom surface of the integrated circuit die.

In one or more embodiments, the package further includes a lead frame including the die pad structure and a plurality of leads.

In one or more embodiments, the package further includes a plurality of wirebonds, where at least one of the plurality of wirebonds electrically connects the integrated circuit die to at least one of the plurality of leads of the lead frame.

In one or more embodiments, the package further includes molding material that encapsulates the integrated circuit die and the lead frame.

In one or more embodiments, the package further includes the integrated circuit die has a first thickness of less than or equal to 75 µm, and a bond line thickness between the integrated circuit die and the upper surface of the die pad structure is greater than or equal to 30 µm.

In one or more embodiments, the die attach material includes silver sinter material.

In one or more embodiments, the metallic ink of the standoff structures includes silver.

In one or more embodiments, the die attach material laterally surrounds the standoff structures and fills a space between the integrated circuit die and the die pad structure.

Although the operations of the method(s) herein are shown and described in a particular order, the order of the operations of each method may be altered so that certain operations may be performed in an inverse order or so that certain operations may be performed, at least in part, concurrently with other operations. In one or more other embodiments, instructions or sub-operations of distinct operations may be implemented in an intermittent and/or alternating manner.

As used herein the terms "circuit" and "circuitry," including the term "processing circuitry" and related terminology means any suitable combination(s) of analog or digital circuit elements, hardware, firmware, software, and the like; including but not limited to, application-specific integrated circuits (ASICs), field programmable gate arrays (FPGAs), microcontrollers, and microprocessors. It will be understood that the term "circuitry" encompasses nonvolatile and volatile memory devices including, but not limited to random access memory (RAM), read-only memory (ROM), and the like, which can be implemented using any suitable devices, such as SRAM, DRAM, or magnetic storage devices as non-limiting examples.

While at least one exemplary embodiment has been presented in the foregoing detailed description, it should be appreciated that a vast number of variations exist. It should also be appreciated that exemplary embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. A method comprising:
forming standoff structures on a bottom surface of an integrated circuit die, wherein the standoff structures comprise metallic ink; and
attaching the integrated circuit die to a die pad structure using die attach material, wherein the standoff structures contact a surface of the die pad structure after attachment of the integrated circuit die to the die pad structure.

2. The method of claim 1, wherein forming the standoff structures on the bottom surface of the integrated circuit die comprises:
forming at least three standoff structures on the bottom surface of the integrated circuit die.

3. The method of claim 1, wherein forming the standoff structures on the bottom surface of the integrated circuit die comprises:
printing patterned metallic ink on the bottom surface of the integrated circuit die.

4. The method of claim 3, further comprising:
dicing a wafer comprising the integrated circuit die to separate the integrated circuit die from the wafer.

5. The method of claim 4, wherein forming the standoff structures is performed prior to dicing the wafer.

6. The method of claim 4, wherein forming the standoff structures is performed after dicing the wafer.

7. The method of claim 1, further comprising:
forming one or more wire bonds between the integrated circuit die and at least one lead of a lead frame that includes the die pad structure.

8. The method of claim 7, further comprising:
encapsulating the integrated circuit die and the lead frame in molding material.

9. The method of any preceding claim, wherein the die attach material comprises silver sinter material.

10. The method of any preceding claim, wherein, after attaching the integrated circuit die to a die pad structure, the die attach material laterally surrounds the standoff structures and fills a space between the integrated circuit die and the die pad structure.

11. A package comprising:
an integrated circuit die comprising:
standoff structures disposed on a bottom surface of the integrated circuit die, wherein the standoff structures comprise metallic ink;
a die pad structure on which the integrated circuit die is disposed, wherein the standoff structures of the integrated circuit die contact an upper surface of the die pad structure; and
die attach material disposed between the integrated circuit die and the die pad structure, wherein the die attach material attaches the integrated circuit die to the die pad structure.

12. The package of claim 11, wherein the standoff structures comprise at least three standoff structures.

13. The package of claim 12, wherein at least two of the standoff structures are disposed at corner regions of the bottom surface of the integrated circuit die.

14. The package of claim 11, further comprising:
a lead frame comprising the die pad structure and a plurality of leads.

15. The package of claim 14, further comprising:
a plurality of wirebonds, wherein at least one of the plurality of wirebonds electrically connects the integrated circuit die to at least one of the plurality of leads of the lead frame.
